# EUROPÄISCHE PATENTSCHRIFT

(11) **EP 1 722 416 B1**
(45) Veröffentlichungstag und Bekanntmachung des Hinweises auf die Patenterteilung: **14.11.2012**
(21) Anmeldenummer: 06009197.2
(22) Anmeldetag: 04.05.2006
(51) Int. Cl.: H01L 23/58

(54) **Integrierter Schaltkreis mit Abgleichelementen und Verfahren zu seiner Herstellung**
Integrated circuit with trimming elements and method
Circuit intégré aux éléments de l'ajustage et méthode

(30) Priorität: 10.05.2005 DE 102005022600
(43) Veröffentlichungstag der Anmeldung: 15.11.2006
(73) Patentinhaber: Atmel Automotive GmbH, 74072 Heilbronn (DE)
(72) Erfinder: Jürgen Häfner, 74257 Untereisesheim (DE); Alexander Kurz, 74523 Schwäbisch Hall (DE); Wolfgang Sinderhauf, 74172 Neckarsulm (DE); Dr. Matthias Tortschanoff, NE29 6WT North Shields (GB); Ulrich Wicke, 74078 Heilbronn (DE)
(74) Vertreter: Grünecker, Kinkeldey, Stockmair & Schwanhäusser

(56) Entgegenhaltungen:
- EP-A2- 1 294 017
- US-A1- 2002 084 512
- US-A1- 2003 032 263

## Beschreibung

Die Erfindung betrifft einen Integrierten Schaltkreis mit Abgleichelementen, die in einem ersten Fertigungszustand über Leiterbahnen an außerhalb des Integrierten Schaltkreises liegende Anschlussflächen angeschlossen sind.

Integrierte Schaltkreise mit Abgleichelementen sind per se bekannt, beispielsweise aus JP-A-06120308. Die Abgleichelemente bestehen z. B. aus einer Parallelschaltung eines Widerstandes und einer Diode, wobei das Abgleichelement zwischen einem innerhalb des Integrierten Schaltkreises herrschenden Pluspotential und einem Bezugspotential liegen, das im Halbleitersubstrat des Integrierten Schaltkreises herrscht. Über die Leiterbahn ist das Abgleichelement an eine außerhalb des Integrierten Schaltkreises liegende Anschlussfläche, ein sogenanntes zap-pad, angeschlossen. Über die Anschlussfläche und die Leiterbahn werden den Abgleichelementen ggf. Stromimpulse zugeführt, mit denen die Diode wahlweise in einen dauerhaft leitfähigen Zustand versetzt wird, so dass der zur Diode parallel liegende Widerstand wahlweise kurzgeschlossen wird. Durch diesen einmalig stattfindenden Vorgang werden elektrische Parameter des Integrierten Schaltkreises einmalig im Rahmen eines Fertigungsprozesses bitweise abgeglichen, wobei der Leitfähigkeitszustand der Diode (dauerhaft leitend oder dauerhaft sperrend) einem bit entspricht.

Nach dem Abgleich wird der zusammen mit anderen Integrierten Schaltkreisen in einem Wafer gefertigte Integrierte Schaltkreis vereinzelt. Das Vereinzeln geschieht in der Regel durch einen mechanischen Trennvorgang, zum Beispiel durch einen Sägeschnitt, der durch die außerhalb des Integrierten Schaltkreises liegenden Anschlussflächen geführt wird. Zum Vereinzeln sind die auf einem Wafer produzierten Integrierten Schaltkreise durch die sogenannte Scribeline voneinander separiert. Der Sägeschnitt wird innerhalb der Scribeline durchgeführt. Bei dem Vereinzeln kann es passieren, dass Metall der Anschlussflächen in der Trennfläche durch Spanbildung oder durch eine als Folge eines mechanischen Stresses auftretende plastische Verformung verschmiert wird, so dass in der Tiefe des Halbleitermaterials der Integrierten Schaltung zwischen dem Halbleitermaterial und den Anschlussflächen liegende dielektrische Schichten überbrückt werden. In diesem Fall können im Halbleitersubstrat herrschende Potentiale über die zum Beispiel durch einen Metallspan gebildete Metallbrücke in das Abgleichelement hineinwirken und den elektrischen Parameter, der eigentlich durch den Abgleichvorgang festgelegt werden sollte, in unerwünschter Weise verändern. Eine solche Metallbrücke verursacht also einen Nebenschluss zwischen dem Bezugspotential im Halbleitersubstrat und dem betroffenen Abgleichelement.

Vor diesem Hintergrund besteht die Aufgabe der Erfindung in der Angabe eines Integrierten Schaltkreises mit Abgleichelementen, bei dem ein solches Nebenschlussrisiko minimiert ist.

Diese Aufgabe wird bei einem Wafer der eingangs genannten Art dadurch gelöst, dass wenigstens eine der Leiterbahnen an der Oberfläche eines Bereichs liegt, der aus Halbleitermaterial besteht und der durch einen pn-Übergang von weiterem Halbleitermaterial isoliert ist, das an den Bereich angrenzt.

Durch diese Merkmale wird das genannte Nebenschlussrisiko minimiert. Der pn-Übergang stellt eine zusätzliche Isolationsstruktur dar, die in die Tiefe des Halbleitersubstrats integriert ist und kein zusätzliches Volumen beansprucht. Außerdem sind auch keine zusätzlichen Fertigungsschritte erforderlich, da der Bereich bei ohnehin zur Strukturierung des Integrierten Schaltkreises erfolgenden Lithografie-, Masken- und Dotierungsschritten gewissermaßen nebenbei erzeugt werden kann. Durch eine Steuerung von Prozessparametern bei den genannten Schritten ist die Ausdehnung des Bereichs und damit die Entfernung des isolierenden pn-Übergangs von durchgetrennten Metallquerschnitten sowohl in lateraler als auch in vertikaler Richtung ohne Beeinträchtigung der für den Integrierten Schaltkreis zur Verfügung stehenden Fläche einstellbar. Mit Blick auf Ausgestaltungen des Schaltkreises ist bevorzugt, dass die wenigstens eine Leiterbahn zwischen dem Integrierten Schaltkreis und einer Kante der Anschlussfläche verläuft, deren Abstand zum Integrierten Schaltkreis kleiner ist als Abstände zwischen weiteren Kanten der Anschlussfläche und dem Integrierten Schaltkreis.

Mit anderen Worten: Die Leiterbahn verläuft bei dieser Ausgestaltung zwischen der Anschlussfläche und dem Integrierten Schaltkreis. Durch diese platzsparende Anordnung kann bei gegebener lateraler Ausdehnung des Integrierten Schaltkreises und der Anschlussflächen eine maximale Anzahl von Anschlussflächen an einer Seite des Integrierten Schaltkreises angeordnet werden, was zu einer entsprechenden Maximalzahl von Abgleichmöglichkeiten führt.

Bevorzugt ist auch, dass ein nach einer Vereinzelung des Integrierten Schaltkreises noch mit dem Integrierten Schaltkreis verbundener Rest der Anschlussfläche und/oder der Leiterbahn durch den Bereich und den pn-Übergang vollständig von benachbartem Halbleitermaterial isoliert ist.

Der Bereich erstreckt sich also unter der Leiterbahn zumindest bis zu einer bei der Vereinzelung entstehenden Trennfläche. Dadurch wird das Risiko von Nebenschlüssen, die als Folge von bei der Vereinzelung in der Trennfläche auftretenden Metallverschmierungen entstehen könnten, minimiert.

Im Rahmen einer alternativen Ausgestaltung ist bevorzugt, dass die wenigstens eine Leiterbahn teilweise neben einer Anschlussfläche verläuft und im ersten Fertigungszustand mit der Anschlussfläche verbunden und in einem zweiten Fertigungszustand von der Anschlussfläche getrennt ist.

Diese Ausgestaltung stellt bereits in Verbindung mit den gattungsbildenden Merkmalen eine alternative Lösung der oben genannten Aufgabe dar.

Die Leiterbahn besitzt in der Trennebene einen kleineren Querschnitt als die Anschlussfläche. Dadurch, dass die Leiterbahn im zweiten Fertigungszustand von der Anschlussfläche getrennt ist, wird der potentiell Nebenschlüsse verursachende Metallquerschnitt auf den kleineren Querschnitt der Leiterbahn beschränkt, was die Wahrscheinlichkeit von Nebenschlüssen weiter reduziert. Der Querschnitt der Leiterbahn kann um drei Zehnerpotenzen kleiner sein als der Querschnitt der Anschlussfläche. Da der größere Querschnitt der Anschlussfläche im zweiten Fertigungszustand nicht mehr über die Leiterbahn mit dem Abgleichelement verbunden ist, können sich Metallbrücken aus dem Querschnitt der Anschlussfläche nicht auf das Abgleichelement auswirken. Aus diesem Grund können die Merkmale dieser Ausgestaltung ergänzend zu der Sperrschichtisolation die oben genannte Aufgabe lösen.

Ferner ist bevorzugt, dass die Leiterbahn wenigstens teilweise durch eine passivierende Schicht abgedeckt ist.

Die passivierende Schicht, die beispielsweise aus einem Oxid oder Nitrid des Halbleitermaterials bestehen kann, reduziert den mechanischen Stress, der bei dem Vereinzelungsschritt auf den Querschnitt der Leiterbahn einwirkt. Durch die Reduzierung des mechanischen Stresses wird bereits die Wahrscheinlichkeit des Auftretens von Metallverschmierungen reduziert.

Bevorzugt ist auch, dass die Anschlussflächen und die wenigstens eine Leiterbahn bei einem Integrierten Schaltkreis mit einer ersten Metallisierungsebene, die einen kleinen Abstand zum Halbleitermaterial des Schaltkreises aufweist, und einer zweiten Metallisierungsebene, die einen größeren Abstand zum Halbleitermaterial aufweist, nur Metall der zweiten Metallisierungsebene aufweisen.

Dagegen wird bei dem per se bekannten Integrierten Schaltkreis die Anschlussfläche durch eine Übereinanderanordnung der ersten Metallisierungsebene und der zweiten Metallisierungsebene realisiert. Dadurch, dass bei der hier genannten Ausgestaltung nur die zweite Metallisierungsebene, die einen größeren Abstand zum Halbleitermaterial aufweist, für den nach außen gehenden Anschluss des Abgleichelements verwendet wird, erfolgt eine Reduzierung des Metallquerschnitts in der Trennebene und damit eine Verringerung der Größe möglicher Metallbrücken, die Nebenschlüsse verursachen könnten.

Mit Blick auf Alternativen und/oder Ausgestaltungen des Herstellungsverfahrens ist entsprechend bevorzugt, dass die Leiterbahn zwischen dem Integrierten Schaltkreis und einer Kante der Anschlussfläche erzeugt wird, deren Abstand zum Integrierten Schaltkreis kleiner ist als Abstände zwischen weiteren Kanten der Anschlussfläche und dem Integrierten Schaltkreis, so dass wenigstens ein der Leiterbahn zugewandter Teilbereich der Anschlussfläche ebenfalls in dem Bereich liegt.

Der Schaltkreis ist in dem ersten Fertigungszustand zusammen mit anderen Integrierten Schaltkreisen in einem Wafer angeordnet ist und durch einen Vereinzelungsschritt so von den anderen Integrierten Schaltkreisen getrennt wird, dass der Teilbereich in einem zweiten Fertigungszustand durch den pn-Übergang vollständig von benachbartem Halbleitermaterial isoliert ist.

Ferner ist bevorzugt, dass die Leiterbahn vor dem Vereinzelungsschritt wenigstens teilweise durch eine passivierende Schicht abgedeckt wird.

Bevorzugt ist auch, dass die wenigstens eine Leiterbahn so erzeugt wird, dass sie teilweise neben einer Anschlussfläche verläuft, der Schaltkreis in dem ersten Fertigungszustand zusammen mit anderen Integrierten Schaltkreisen in einem Wafer angeordnet ist und durch einen Vereinzelungsschritt so von den anderen Integrierten Schaltkreisen getrennt wird, dass ein Rest der Leiterbahn in einem zweiten Fertigungszustand von der Anschlussfläche getrennt ist.

Durch diese Ausgestaltungen des Herstellungsverfahrens werden die bei den weiter oben genannten Ausgestaltungen des Schaltkreises bereits genannten Vorteile erzielt.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Figur 1: eine Draufsicht auf einen Teil eines Integrierten Schaltkreises mit einem Abgleichelement und außerhalb des Integrierten Schaltkreises liegenden Anschlussflächen;
- Figur 2: einen Schnitt durch den Integrierten Schaltkreis der Figur 1;
- Figur 3: eine Draufsicht auf eine alternative Ausgestaltung des Integrierten Schaltkreises mit einer alternativen Führung der Leiterbahnen;
- Figur 4: einen Schnitt durch den Integrierten Schaltkreis der Figur 3; und
- Figur 5: einen Schnitt durch einen Integrierten Schaltkreis, der zwei Metallisierungsebenen aufweist.

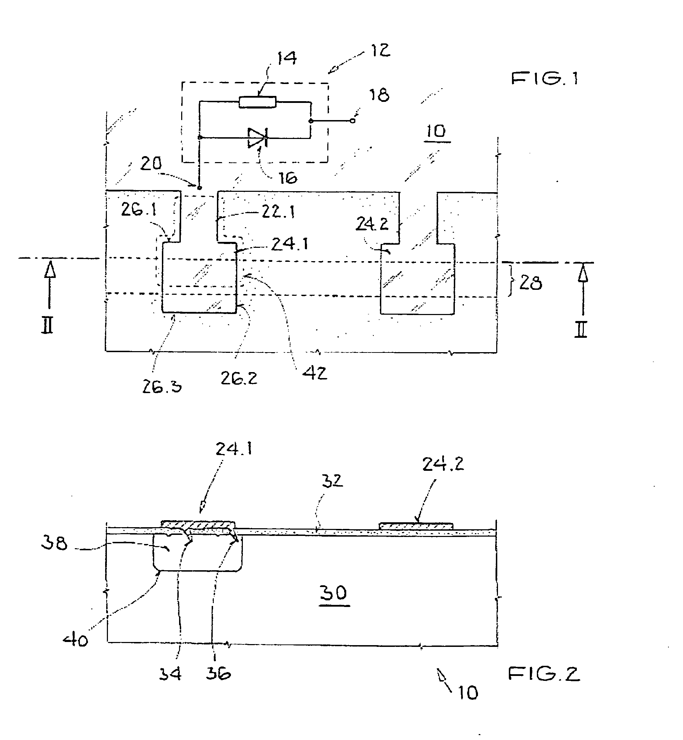

Im Einzelnen zeigt die Figur 1 einen Integrierten Schaltkreis 10 mit einem Abgleichelement 12, das hier stellvertretend für eine Vielzahl von Abgleichelementen des Integrierten Schaltkreises 10 dargestellt ist und das einen Ohm'schen Widerstand 14 und eine dazu parallel liegende Diode 16 aufweist. Elektrisch gesehen liegt das Abgleichelement 12 zwischen einem ersten Anschluss 18 im Integrierten Schaltkreis 10 und einem zweiten Anschluss 20, der eine Verbindung des Abgleichelementes 12 zu einer aus dem Integrierten Schaltkreis 10 herausführenden Leiterbahn 22.1 repräsentiert.

Die Leiterbahn 22.1 führt zu einer Anschlussfläche 24.1, über die der zweite Anschluss 20 mit einer Mess- und Abgleichvorrichtung verbunden werden kann, die in der Figur 1 nicht dargestellt ist. Die Mess- und Abgleichvorrichtung weist z. B. eine Kontaktspinne auf, deren Beine auf die Anschlussfläche 24.1 und weitere Anschlussflächen 24.2 usw. aufgesetzt werden und über die elektrische Impulse in das Abgleichelement 12 eingespeist werden. Dabei werden die elektrischen Impulse so vorbestimmt, dass die Diode 16 wahlweise in ihrer Funktion (Sperrwirkung für eine Stromrichtung) erhalten bleibt oder einmalig in einen dauerhaft leitenden Zustand (keine Sperrwirkung) versetzt wird, in dem der Widerstand 14 für beide möglichen Stromrichtungen durch die Diode 16 kurzgeschlossen wird.

Auf diese Weise wird ein über den ersten Anschluss 18 des Abgleichelements 12 beeinflussbarer Parameter des Integrierten Schaltkreises 10 bitweise eingestellt. Dabei versteht es sich, dass ein Abgleichelement 12 auch anders aufgebaut sein kann als es in der Figur 1 dargestellt ist. Die Darstellung der inneren Struktur des Abgleichelements in der Figur 1 dient daher nur der Veranschaulichung des grundsätzlichen Prinzips solcher Abgleichelemente 12.

In der Ausgestaltung der Figur 1 verläuft die Leiterbahn 22.1 parallel zur kürzest möglichen Verbindung zwischen der Anschlussfläche 24.1 und dem zweiten Anschluss 20 im Integrierten Schaltkreis 10. Mit anderen Worten: Die wenigstens eine Leiterbahn 22.1 verläuft zwischen dem Integrierten Schaltkreis 10 und einer Kante 26.1 der Anschlussfläche 24.1, deren Abstand zum Integrierten Schaltkreis 10 kleiner ist als Abstände zwischen weiteren Kanten 26.2, 26.3 der Anschlussfläche 24.1 und dem Integrierten Schaltkreis 10.

Der Integrierte Schaltkreis 10 befindet sich in der Darstellung der Figur 1 zusammen mit anderen Integrierten Schaltkreisen in einem ersten Fertigungszustand in einem gemeinsamen Wafer. Nach dem beschriebenen Abgleich seiner elektrischen Parameter erfolgt eine Überführung des Integrierten Schaltkreises 10 in einen zweiten Fertigungszustand durch einen sogenannten Vereinzelungsschritt. Die Vereinzelung erfolgt zum Beispiel durch einen Sägeschnitt innerhalb der sogenannten Scribeline. Die Sägeschnittlinie 28 führt durch die nach dem Abgleich nicht mehr benötigten Anschlussflächen 24.1, 24.2, so dass diese zerstört werden.

Figur 2 stellt eine Ansicht der Schnittfläche (Sägefläche) eines vereinzelten Integrierten Schaltkreises 10 aus der Figur 1 dar, der längs der Linie II-II durchgesägt worden ist. Dabei zeigt die rechte Hälfte der Figur 2 mit dem Schnitt durch die Anschlussfläche 24.2 den theoretischen Idealfall eines Sägeschnittes, der die Struktur des Integrierten Schaltkreises 10 in der Trennfläche nicht verändert. Dann wird insbesondere eine zwischen einem Halbleitersubstrat 30 und der Anschlussfläche 24.2 liegende dielektrische Schicht 32 nicht beschädigt und es treten auch keine Verschmierungen des Metalls der Anschlussfläche 24.2 auf.

Tatsächlich verursacht der beim Sägen auftretende mechanische Stress jedoch Strukturveränderungen, wie sie in der linken Hälfte der Figur 2 dargestellt sind. Kritisch ist insbesondere eine Bildung von Spänen des Metalls der Anschlussflächen oder Verschmierungen des Metalls der Anschlussflächen, also Veränderungen des Querschnitts der metallischen Anschlussflächen durch plastische Verformungen. Wie in der Figur 2 am Beispiel der Anschlussfläche 24.1 dargestellt ist, können solche plastischen Verformungen zu Metallbrücken 34, 36 führen, die sich über die dielektrische Schicht 32 hinaus bis in das darunter liegende Halbleitermaterial des Halbleitersubstrats 30 erstrecken. Ohne weitere Gegenmaßnahme kann dies dazu führen, dass ein im Halbleitersubstrat 30 herrschendes Bezugspotential über die Metallbrücken 34, 36 und die Reste der Anschlussfläche 24.1 sowie über die Leiterbahn 22.1 und das Abgleichelement 12 den vorher abgeglichenen elektrischen Parameter des Integrierten Schaltkreises 10 unerwünscht beeinflusst, indem z. B. ein Leckstrom vom ersten Anschluss 18 über das Abgleichelement 12, die Leiterbahn 22.1, den Rest der Anschlussfläche 24.1 und die Metallbrücken 34, 36 in das Halbleitersubstrat 30 möglich wird.

In der Ausgestaltung der linken Hälfte der Figur 2 werden solche unerwünschten Leckströme durch einen Bereich 38 aus Halbleitermaterial verhindert, der durch einen pn-Übergang 40 von weiterem Halbleitermaterial des Halbleitersubstrats 30, das an den Bereich 38 angrenzt, isoliert ist. Das Halbleitermaterial des Bereichs 38 weist also einen anderen Leitfähigkeitstyp auf als das angrenzende Halbleitermaterial des Halbleitersubstrats 30. Wenn das Halbleitersubstrat 30 vom p-Leitfähigkeitstyp ist, weist das Halbleitermaterial des Bereichs 38 eine n-Leitfähigkeit auf. Zusammen mit den o. a. Potentialverhältnissen, also einem positiven Potential am ersten Anschluss 18 und einem (dazu negativen) Bezugspotential im Halbleitersubstrat 30 wird der Bereich 38 dann, wenn Metallbrücken 34, 36 auftreten, gewissermaßen positiv aufgeladen, so dass der pn-Übergang 40 automatisch in Sperrrichtung gepolt wird und einen Leckstrom über die Metallbrücken 34, 36 in das Halbleitermaterial des Halbleitersubstrats 30 verhindert.

Um diese erwünschte Wirkung zu erzeugen, muss der Bereich 38 eine hinreichende Ausdehnung besitzen. Er muss also auf jeden Fall in der Ebene des Sägeschnitts II-II in der Figur 1 liegen und in der Figur 2 so tief und so breit sein, dass er nicht ebenfalls durch die Metallbrücken 34, 36 überbrückt wird. Erfahrungsgemäß reicht dazu eine Ausdehnung von ca. 10 µ in die Tiefe des Halbleitersubstrats 30 sowie ein seitlicher Überstand von jeweils ca. 10 p, gemessen von der rechten und linken Kante der Anschlussfläche 24.1, aus. Es versteht sich aber, dass in Abhängigkeit vom mechanischen Stress, der beim Sägevorgang auftritt, und in Abhängigkeit von der Querschnittsfläche des durchtrennten Metalls auch andere Werte erforderlich sein können.

In Richtung der Leiterbahn 22.1 der Figur 1 wird der Bereich bevorzugt so weit ausgedehnt, dass er sich unterhalb der Leiterbahn 22.1 erstreckt, um sicherzustellen, dass die Schnittebene II-II in der Figur 1 auch bei einer Verschiebung der Sägeschnittlinie 28 aufgrund von Fertigungstoleranzen sicher durch den Bereich 38 verläuft. Bei der Lage der Sägeschnittlinie 28, wie sie in der Figur 1 dargestellt ist, muss sich der Bereich 38 auch noch etwas unter die Anschlussfläche 24.1 erstrecken. Dadurch wird sichergestellt, dass ein nach einer Vereinzelung des Integrierten Schaltkreises 10 noch mit dem Integrierten Schaltkreis 10 verbundener Rest der Anschlussfläche 24.1 und/oder der Leiterbahn 22.1 durch den Bereich 38 und den pn-Übergang 40 vollständig von benachbartem Halbleitermaterial des Halbleitersubstrats 30 isoliert ist. Die gestrichelte Linie 42 in der Figur 1 deutet einen möglichen Verlauf der Grenzen des Bereichs 38 und damit des pn-Übergangs 40 bei einer Ansicht von oben an.

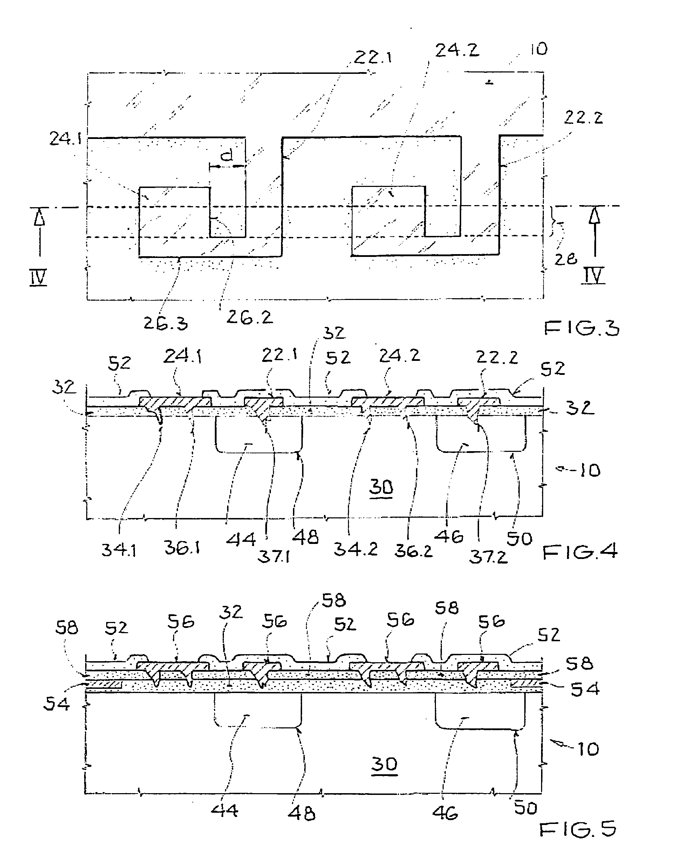

Figur 3 zeigt einen alternativen Verlauf von Leiterbahnen 22.1, 22.2, die in einem ersten Fertigungszustand Anschlussflächen 24.1, 24.2 mit dem Integrierten Schaltkreis 10 verbinden. Die elektrisch leitfähigen Pfade 22.1, 22.2 verlaufen hier nicht mehr auf dem kürzesten Weg zwischen den Anschlussflächen 24.1, 24.2 und dem Integrierten Schaltkreis 10, sondern jeweils teilweise neben einer Anschlussfläche 24.1, 24.2 in einem Abstand d, um dann L-förmig abzuknicken und die Anschlussflächen 24.1, 24.2 seitlich an einer Kante 26.2 oder auch von der Rückseite, an einer Kante 26.3, anzuschließen.

Im Unterschied zum Gegenstand der Figuren 1, 2 werden beim Gegenstand der Fig. 3 Reste der Anschlussflächen 24.1, 24.2, die nach einem Abgleich elektrischer Parameter und einem Vereinzeln des Integrierten Schaltkreises 10 durch einen Sägeschnitt längs der Scribeline 28 übrig bleiben, vollständig von ihren jeweils zugeordneten Leiterbahnen 22.1, 22.2 und damit auch von dem Integrierten Schaltkreis 10 getrennt. Figur 4 zeigt die durch den längs der Linie IV-IV in der Figur 3 entstandene Schnittfläche des Integrierten Schaltkreises 10.

Aufgrund der Trennung können sich Metallbrücken 34.1, 36.1, 34.2, 36.2 der Anschlussflächen 24.1, 24.2 nicht mehr negativ auf den Integrierten Schaltkreis 10 auswirken. Leckströme können überhaupt nur noch durch Metallbrücken 37.1. 37.2 bildende plastische Verformungen der Querschnitte der Leiterbahnen 22.1 und 22.2 übertragen werden.

Da die Querschnittsflächen der Leiterbahnen 22.1, 22.2 jedoch kleiner als die Querschnitte der Anschlussflächen 24.1, 24.2 sind, ergibt sich bereits eine verringerte Nebenschlusswahrscheinlichkeit, so dass die Wegführung der Leiterbahnen 22.1, 22.2 nach den Figuren 3 und 4 die Aufgabe lösen kann. Diese verringerte Nebenschlusswahrscheinlichkeit wird weiter durch die Bereiche 44 und 46 sowie die als Folge der Bereiche 44, 46 auftretenden pn-Übergänge 48 und 50 verringert. Außerdem verhindern die Bereiche 44 und 46 in Verbindung mit den pn-Übergängen 48 und 50 eine niederohmige Verbindung zwischen den Leiterbahnen 22.1 und 22.2. Für die Dotierung der Bereiche 44 und 46, die den Leitfähigkeitstyp der Bereiche 44 und 46 bestimmt, sowie für den Leitfähigkeitstyp des die Bereiche 44, 46 umgebenden Halbleitersubstrates 30 gelten die entsprechenden Ausführungen zum Bereich 38 und dem Halbleitersubstrat 30 in der Erläuterung zur Fig. 2.

Ein weiterer Vorteil des Gegenstandes der Figur 4 liegt darin, dass die Leiterbahnen 22.1, 22.2 vor dem Abgleich mit einer passivierenden Schicht 52 bedeckt werden können, die beim anschließenden Vereinzelungsschritt den mechanischen Stress, der auf die Querschnitte der Leiterbahnen 22.1, 22.2 wirkt, reduziert. Die Anschlussflächen 24.1, 24.2 können dagegen nicht ohne Weiteres mit der passivierenden Schicht 52 bedeckt werden, da sie ja für den Abgleich von außen kontaktiert werden müssen.

Insgesamt ergibt sich beim Gegenstand der Figur 4 eine Verringerung der Nebenschlusswahrscheinlichkeit durch drei Maßnahmen. Die erste Maßnahme besteht in der Ausbildung von Bereichen 44, 46 und pn-Übergängen 48, 50 unter den Leiterbahnen 22.1, 22.2. Die zweite Maßnahme besteht in der geänderten Wegführung, die für eine Trennung der Reste der Anschlussflächen 24.1 und 24.2 von den Leiterbahnen 22.1, 22.2 im zweiten Fertigungszustand der Integrierten Schaltung 10 nach dem Vereinzelungsschritt führt. Die dritte Maßnahme besteht in dem Abdecken der Leiterbahnen mit einer passivierenden Schicht 52, beispielsweise einem schützenden Oxid.

Figur 5 verdeutlicht einen weiteren Unterschied zum Stand der Technik, der ebenfalls bevorzugt in Kombination mit wenigstens einer der genannten Maßnahmen realisiert wird. Üblicherweise weisen Integrierte Schaltkreise 10 wenigstens zwei Metallisierungsebenen 54, 56 auf, wobei die Anschlussflächen beim Stand der Technik durch einen Stapel von Anschlussflächen aus einer ersten Metallisierungsebene 54 und einer zweiten Metallisierungsebene 56 realisiert werden. Dadurch entsteht eine vergleichsweise große Metallquerschnittsfläche, aus der durch plastische Verformungen entsprechend große Metallbrücken wachsen können. Im Rahmen einer Ausgestaltung der Erfindung ist daher bevorzugt, nur eine der beiden Metallisierungsebenen 54, 56 für die Anschlussflächen zu verwenden. Im Beispiel der Figur 5 ist dies die obere, zweite Metallisierungsebene 56, die von der unteren, ersten Metallisierungsebene 54 durch eine weitere dielektrische Schicht 58 getrennt ist. Diese weitere dielektrische Schicht 58 bringt den zusätzlichen Vorteil, dass der Abstand zwischen den Anschlussflächen und dem Halbleitersubstrat 30 weiter vergrößert wird, was ebenfalls die Wahrscheinlichkeit der Bildung von Nebenschlüssen beim Vereinzelungsschritt verringert.

## Patentansprüche

1. Wafer mit einer Mehrzahl von Integrierten Schaltkreisen (10) mit Abgleichelementen (12), wobei die Integrierten Schaltkreise (10) durch Sägeschnittlinien (28) voneinander separiert sind, wobei die Abgleichelemente (12) in einem ersten Fertigungszustand über Leiterbahnen (22.1, 22.2) an außerhalb des Integrierten Schaltkreises (10) liegende Anschlussflächen (24.1, 24.2) angeschlossen sind,
**dadurch gekennzeichnet, dass**
wenigstens eine der Leiterbahnen (22.1, 22.2) auf einem Bereich (38; 44, 46) liegt, der aus Halbleitermaterial besteht und durch einen pn-Übergang (40; 48, 50) von weiterem Halbleitermaterial isoliert ist, das an den Bereich (38; 44, 46) angrenzt, und der Bereich sich zumindest unter den Abschnitten der Leiterbahnen, die der Sägeschnittlinie entsprechen, erstreckt.

2. Wafer (10) nach Anspruch 1, **dadurch gekennzeichnet, dass** die wenigstens eine Leiterbahn (22.1) zwischen dem Integrierten Schaltkreis (10) und einer Kante (26.1) der Anschlussfläche (24.1) verlauft, deren Abstand zum Integrierten Schaltkreis (10) kleiner ist als Abstände zwischen weiteren Kanten (26.2, 26.3) der Anschlussfläche (24.1) und dem Integrierten Schaltkreis (10).

3. Wafer (10) nach Anspruch 2, **dadurch gekennzeichnet, dass** ein nach einer Vereinzelung des Integrierten Schaltkreises (10) noch mit dem Integrierten Schaltkreis (10) verbundener Rest der Anschlussflache (24.1) und/oder der Leiterbahn (22.1) durch den Bereich (38) und den pn-Übergang (40) vollständig von benachbartem Halbleitermaterial isoliert ist.

4. Wafer (10) nach Anspruch 1, **dadurch gekennzeichnet, dass** die wenigstens eine Leiterbahn (22.1) teilweise neben einer Anschlussfläche (24.1) verlauft und im ersten Fertigungszustand mit der Anschlussfläche (24.1) verbunden und in einem zweiten Fertigungszustand von der Anschlussfläche (24.1) getrennt ist.

5. Wafer (10) nach Anspruch 4, **dadurch gekennzeichnet, dass** die wenigstens eine Leiterbahn (22.1) wenigstens teilweise durch eine passivierende Schicht (52) abgedeckt ist.

6. Wafer (10) nach wenigstens einem der vorhergehenden Anspruche, **dadurch gekennzeichnet, dass** die Anschlussflächen (24.1, 24.2) und die wenigstens eine Leiterbahn (22.1) bei einem Integrierten Schaltkreis (10) mit einer ersten Metallisierungsebene (54), die einen kleinen Abstand zu Halbleitermaterial des Schaltkreises (10) aufweist, und einer zweiten Metallisierungsebene (56), die einen größeren Abstand zum Halbleitermaterial aufweist, nur Metall der zweiten Metallisierungsebene (56) aufweisen.

## Claims

1. Wafer with a plurality of integrated circuits (10) with adjusting elements (12), which integrated circuits (10) are separated from one another by saw cut lines (28), and the adjusting elements (12) are connected to terminal pads (24.1, 24.2) lying outside the integrated circuit (10) via tracks (22.1, 22.2) in a first manufacturing state,
**characterised in that**
at least one of the tracks (22.1, 22.2) lies on a region (38; 44, 46) made from semiconductor material and is isolated from other semiconductor material by a pn junction (40; 48, 50) adjacent to the region (38; 44, 46), and the region extends at least underneath the portions of the tracks corresponding to the saw cut line.

2. Wafer (10) as claimed in claim 1, **characterised in that** the at least one track (22.1) extends between the integrated circuit (10) and an edge (26.1) of the terminal pad (24.1), the distance of which from the integrated circuit (10) is shorter than distances between other edges (26.2, 26.3) of the terminal pad (24.1) and the integrated circuit (10).

3. Wafer (10) as claimed in claim 2, **characterised in that** a remainder of the terminal pad (24.1) and/or the track (22.1) still connected to the integrated circuit (10) after separating the integrated circuit (10) is completely isolated from the adjacent semiconductor material by the region (38) and the pn junction (40).

4. Wafer (10) as claimed in claim 1, **characterised in that** the at least one track (22.1) extends partially adjacent to a terminal pad (24.1) and is connected to the terminal pad (24.1) in the first manufacturing state and is separated from the terminal pad (24.1) in a second manufacturing state.

5. Wafer (10) as claimed in claim 4, **characterised in that** the at least one track (22.1) is at least partially covered by a passivating layer (52).

6. Wafer (10) as claimed in at least one of the preceding claims, **characterised in that** the terminal pads (24.1, 24.2) and the at least one track (22.1) in an integrated circuit (10) with a first metallisation level (54) disposed at a short distance from semiconductor material of the circuit (10) and a second metallisation level (56) at a greater distance from the semiconductor material have only metal of the second metallisation level (56).

## Revendications

1. Plaquette avec plusieurs circuits intégrés (10) pourvus d'éléments d'ajustage (12), étant précisé que les circuits intégrés (10) sont séparés les uns des autres par des lignes de sciage (28) et que les éléments d'ajustage (12) sont raccordés lors d'un premier état de fabrication à des surfaces de raccordement (24.1, 24.2) situées à l'extérieur du circuit intégré (10), par l'intermédiaire de pistes conductrices (22.1, 22.2),
**caractérisée en ce que** l'une au moins des pistes conductrices (22.1, 22.2) se trouve sur une zone (38, 44, 46) qui se compose d'un matériau semi-conducteur et qui est isolée d'un autre matériau semi-conducteur par une jonction pn (40 ; 48, 50) voisine de ladite zone (38 ; 44, 46), et la zone s'étend au moins sous les sections des pistes conductrices qui correspondent à la ligne de sciage.

2. Plaquette (10) selon la revendication 1, **caractérisée en ce que** la ou les pistes conductrices (22.1) s'étendent entre le circuit intégré (10) et un bord (26.1) de la surface de raccordement (24.1) dont l'écartement par rapport au circuit intégré (10) est plus petit que les écartements entre d'autres bords (26.2, 26.3) de la surface de raccordement (24.1) et le circuit intégré (10).

3. Plaquette (10) selon la revendication 2, **caractérisée en ce qu'**un reste de la surface de raccordement (24.1) et/ou de la piste conductrice (22.1) qui est encore relié au circuit intégré (10) après une séparation dudit circuit intégré (10) est complètement isolé du matériau semi-conducteur voisin par la zone (38) et la jonction pn (40).

4. Plaquette (10) selon la revendication 1, **caractérisée en ce que** la ou les pistes conductrices (22.1) s'étendent en partie près d'une surface de raccordement (24.1) et sont reliées à la surface de raccordement (24.1), dans le premier état de fabrication, et séparées de ladite
surface de raccordement (24.1), lors d'un deuxième état de fabrication.

5. Plaquette (10) selon la revendication 4, **caractérisée en ce que** la ou les pistes conductrices (22.1) sont au moins en partie couvertes par une couche de passivation (52).

6. Plaquette (10) selon l'une au moins des revendications précédentes, **caractérisée en ce que** les surfaces de raccordement (24.1, 24.2) et la ou les pistes conductrices (22.1), sur un circuit intégré (10) avec un premier plan de métallisation (54) qui présente un petit écartement par rapport au matériau semi-conducteur du circuit (10), et avec un second plan de métallisation (56) qui présente un plus grand écartement par rapport au matériau semi-conducteur, ne comportent que le métal du second plan de métallisation (56).
